# EUROPÄISCHE PATENTANMELDUNG

(11) **EP 1 783 858 A1**
(43) Veröffentlichungstag der Anmeldung: **09.05.2007**
(21) Anmeldenummer: 06020341.1
(22) Anmeldetag: 28.09.2006
(51) Int. Cl.: H01Q 1/32, B29C 45/14

(54) **Trägerfolie mit Antennenstrukturen mit Aussparungen und/oder Einbuchtungen und/oder Markierungen**

(30) Priorität: 28.10.2005 DE 10552097; 15.02.2006 DE 10606924
(71) Anmelder: Hirschmann Car Communication GmbH, 72654 Neckartenzlingen (DE)
(72) Erfinder: Petersen, Ingmar, 73733 Esslingen (DE); Schwarz, Bernd, 72141 Waldorfhäslach (DE); Pletschinger, Markus, 72800 Eningen (DE)
(74) Vertreter: Thul, Hermann

(57) **Zusammenfassung**

Die Erfindung betrifft einen flächigen Träger (1) aus einem elektrisch nicht leitfähigen Material, wobei auf oder in dem Träger (1) elektrisch leitfähige Strukturen (2, 3, 4) auf- oder eingebracht sind, ausgebildet zur Anwendung in einem Fahrzeug, wobei erfindungsgemäß vorgesehen ist, dass der Träger (1) randseitig zumindest eine Einbuchtung (11, 12) und/oder innerhalb seiner flächigen Erstreckung zumindest eine Aussparung (8, 9, 10, 13, 14) und/oder zumindest eine Markierung (19) aufweist.

## Beschreibung

Die Erfindung betrifft einen flächigen Träger aus einem elektrisch nicht leitfähigen Material, wobei auf oder in dem Träger elektrisch leitfähige Strukturen auf- oder eingebracht sind, gemäss den Merkmalen des Oberbegriffes des Patentanspruchs 1.

Solche flächigen Träger aus einem elektrisch nicht leitfähigen Material wie Kunststoff sind bekannt, wobei auf diesem Träger elektrisch leitfähige Strukturen zum Beispiel mit Hilfe des Siebdruckverfahrens aufgebracht wurden.
Eine Anwendung von solchen flächigen Trägern ist aus der RFID-Technik bekannt. Diese flächigen Träger haben aber aufgrund ihrer Funktion keine große Erstreckung, sondern erstrecken sich nur über wenige Zentimeter in der Länge bzw. Breite. Des Weiteren weisen solche Produkte zumeist eine symmetrische Kontur auf, so dass sich die weitere Positionierung, bzw. Ausrichtung als unkompliziert, bzw. wenig fehlerbehaftet erweist.

Das Anwendungsgebiet der vorliegenden Erfindung betrifft allerdings nicht solche Anwendungen, sondern betrifft Träger mit elektrisch leitfähigen Strukturen, bei denen es sich insbesondere um Antennenstrukturen zum Empfangen und/oder Senden hochfrequenter Signale handelt, welche es in Fahrzeuge zu integrieren gilt.

Aus der DE 195 35 250 A1 ist es bekannt, auf oder in einem Fahrzeugbauteil, hier ein Kofferraumdeckel, elektrisch leitfähige Strukturen in Form von Drähten zur Realisierung der Antennenstrukturen einzubringen. Damit ist zwar grundsätzlich eine Antennenleiterstruktur in dem Fahrzeugbauteil bekannt, allerdings gibt es hinsichtlich der Herstellung solcher großflächiger Fahrzeugbauteile mit filigranen Antennenleiterstrukturen große Probleme bei der Abstimmung sowie der Reproduzierbarkeit. Insbesondere beim Ausrichten der Antennenleiterstrukturen innerhalb eines Werkzeuges, mit dem das Fahrzeugbauteil hergestellt wird ergeben sich Problematiken, welche im ungünstigsten Falle zum Ausschuss des Bauteils, oder aber auch zu kostenintensiven Nachbesserungsarbeiten führt. Außerdem kann durch die erhöhte Reproduzierbarkeit eine gleich bleibende Performance der funktionalen Strukturen erreicht oder aber auch stabiler optimiert werden.

Es ist aus den nicht vorveröffentlichten Patentanmeldungen DE 10 2005 034 083.0, DE 10 2005 034 082.2 oder DE 10 2005 034 085.7 schon bekannt, einen flächigen Träger aus einem elektrisch nicht leitfähigen Material, insbesondere eine Kunststofffolie, herzustellen und darauf die elektrisch leitfähigen Bereiche aufzubringen. Nachdem dieser flächige Träger derart hergestellt worden ist, wird er in ein Werkzeug eingelegt. Zur Herstellung eines Zielbauteiles wird das Werkzeug nun mit einem elektrisch nicht leitfähigen Material aufgefüllt, insbesondere ausgeschäumt oder ausgespritzt. Dabei ist die Lagepositionierung des Trägers innerhalb des Werkzeugs maßgeblich für das Gelingen des Verfahrens und für die Qualität des entstehenden Bauteils verantwortlich.

Alternativ zu den in den beschriebenen Herstellungsverfahren kann auch daran gedacht werden, dass der flächige Träger mit den elektrisch leitfähigen Strukturen versehen wird und anschließend mit einem vorgefertigten Zielbauteil lösbar mit z.B. durch Clips oder Schrauben, oder unlösbar mittels einer permanent haftenden Selbstklebefolie verbunden wird.

Ein weiteres, schwerwiegendes Problem entsteht durch die Anwendung von Hinterschäum- bzw. Hinterspritzverfahren, bei welchen der Träger in dem Zielbauteil verbleibt. Der integrierte Träger verschließt in diesem Fall die Oberfläche des gespritzten, bzw. geschäumten Bauteils und behindert somit das Ausgasen des Werkstoffes. Kommt es daraufhin zu einer Gasansammlung unter dem angefügten Träger, ruft dies eine Spannung hervor und zerstört somit die aufgebrachte leitende Struktur. Weiterhin kann es zu einer Ablösung des Trägers führen, bzw. weitere, auf dem angefügten Träger angebrachte Bauteile wie z.B. Patch-Antennen oder Verstärker destabilisieren.

Der Erfindung liegt daher die Aufgabe zugrunde, einen Träger mit elektrisch leitfähigen Strukturen für Fahrzeuge bereitzustellen, mit dem die eingangs geschilderten Nachteile vermieden werden.

Diese Aufgabe ist durch die Merkmale des Patentanspruchs 1 gelöst.

Erfindungsgemäß ist vorgesehen, dass der Träger randseitig zumindest eine Einbuchtung und/oder innerhalb seiner flächigen Erstreckung zumindest eine Aussparung aufweist. Die eine Einbuchtung oder mehrere Einbuchtungen am Rande des Trägers haben mehrere Vorteile. Zum einen dienen sie dazu, den Träger in einem Werkzeug zu positionieren, um die elektrisch leitfähigen Strukturen an den gewünschten Stellen des Zielbauteils nach den noch nicht vorveröffentlichen Patentanmeldungen DE 10 2005 034 083.0, DE 10 2005 034 082.2 oder DE 10 2005 034 085.7 oder artverwandten Verfahren zu integrieren. Die Konturen des einzubringenden Trägers, ob nun mindestens eine Ausbuchtung und/oder eine Aussparung, dient also zur Lagepositionierung in dem Zielbauteil erzeugenden Werkzeug. Dieses Werkzeug kann beispielhaft über Haltedome bzw. -stifte oder auch über eine der Kontur entsprechende Vertiefung verfügen, welche die korrespondierenden Aussparungen des Trägers oder die Kontur des Trägers aufzunehmen vermag und somit den Träger mit den darauf befindlichen leitenden Strukturen in dem Werkzeug ausrichten, bzw. die Strukturen dem entstehenden Zielbauteil an der richtigen Position zur Verfügung stellen.

Zum anderen kann durch die Erfindung der einzubringende Träger für den zu Verfügung stehenden Bauraum optimiert werden. Die der leitenden Struktur zur Verfügung stehende Fläche vergrößert sich hierdurch gegebenenfalls.

Mit Hilfe der Aussparungen wird der Problematik des Ausgasens Rechnung getragen. Zum einen wird die die Oberfläche verschließende Fläche durch Einbuchtungen generell minimiert, zum anderen kann durch das Aussparen von verschiedensten Geometrien, wie z.B. vielen Kreisen, Löchern oder dergleichen, der Ausgangsprozess ungehindert stattfinden. Die freigelegten Bereiche ermöglichen außerdem bei Bedarf die direkte Befestigung von zusätzlichen Komponenten an der Oberfläche des Zielbauteils. Die Befestigung solcher zusätzlichen Komponenten erfolgt vorzugsweise durch Klebeverbindungen oder durch Verschraubungen.

Weiterhin kann der Träger auf seiner Oberfläche angebrachte Markierungen aufweisen, die zum Beispiel durch Aufdrucken, Lasern, Prägen, Ätzen oder dergleichen erzeugt werden können. Als vorteilhaft zeigt sich der Druck von Markierungen während der Erzeugung der leitenden Strukturen, welche kostengünstig im Siebdruckverfahren realisiert werden können. Auch solche Markierungen haben den Zweck und Vorteil, dass einerseits der Träger in einem Werkzeug korrekt in seiner Lage positioniert und fixiert werden kann; somit ist vorstellbar, dass die aufgedruckten Markierungen mit korrespondierenden Merkmalen im Werkzeug zur Deckung und somit in Lage gebracht werden. Andererseits können die Markierungen eine Montagehilfe für die Ausrichtung und Anbringung von elektronischen Geräten, Befestigungsmitteln, Kontaktierungen, oder dergleichen auf dem Träger, bzw. Zielbauteil bilden. Mit Hilfe von Markierungen ist ebenfalls die Überprüfung nachfolgender Prozesse, wie z.B. Stanzen und mechanisches oder thermisches Verformen auf Ihre Genauigkeit hin überprüfbar. Die Markierungen dienen außerdem als Kennzeichnungssystem zu Identifizierungs- und Logistikzwecken.

Aus der vorangegangenen Beschreibung ergibt sich also, dass die Erfindung einen flächig gestalteten Träger, insbesondere eine Kunststofffolie (biegsam oder starr) mit elektrisch leitfähigen Strukturen, insbesondere Antennenleiterstrukturen, bereitstellt, mit dem sowohl die Herstellung eines solchen Trägers als auch seine weitere Verarbeitung deutlich vereinfacht und verbessert wird. Die Einbuchtungen und/oder Aussparungen und/oder Markierungen bieten dabei insbesondere den Vorteil, dass der Träger in einem Werkzeug, insbesondere in einem Spritzguss oder Schäumungswerkzeug, in seiner Sollposition ausgerichtet werden kann. Die beschriebenen Merkmale sind des Weiteren eine Montagehilfe für nachträgliche Anbringungen von elektronischen Geräten, Befestigungsmitteln und dergleichen. Eine gezieltes Aussparen von diversen Partien ermöglicht darüber hinaus die Ausgasung der nach den noch nicht vorveröffentlichen Patentanmeldungen DE 10 2005 034 083.0, DE 10 2005 034 082.2 oder DE 10 2005 034 085.7 prozessierten Zielbauteilen.

Verschiedene Ausgestaltungen der Erfindungen, auf die diese jedoch nicht beschränkt ist, sind im Folgenden beschrieben und anhand der Figuren erläutert.

Es zeigen:
- Figur 1: einen ersten flächigen Träger mit Einbuchtungen und Aussparungen,
- Figur 2: eine zweite Ausführung eines flächigen Trägers,
- Figur 3: den flächigen Träger gemäß Figur 1,2 oder 7, aufgebracht auf einem Zielbauteil,
- Figur 4: den flächigen Träger gemäß Figur 1, 2 oder 7 auf einem vorgefertigten Zielbauteil durch partielle Verklebung aufgebracht,
- Figur 5: den flächigen Träger gemäß Figur 1, 2 oder 7 integriert in ein Zielbauteil durch Hinterspritzen, Hinterschäumen oder Kompressionsmethode (z.B. SMC)
- Figur 6: eine dritte Ausführung eines flächigen Trägers
- Figur 7: den flächigen Träger, zwecks Übertragung der leitenden Strukturen mittels des Transferdrucks.

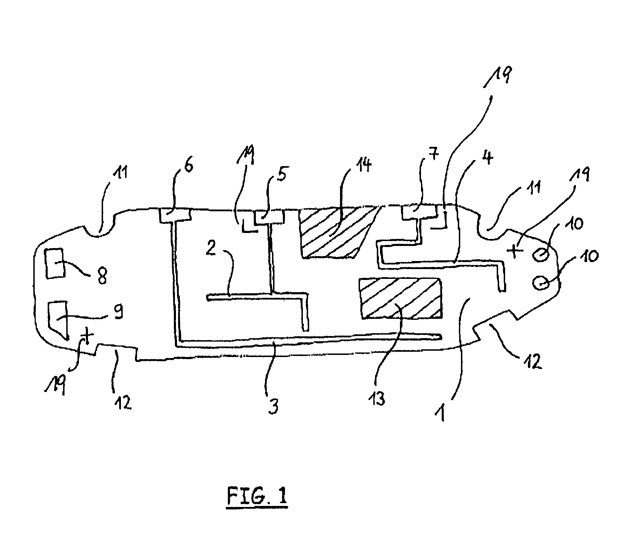

Figur 1 zeigt einen erfindungsgemäß gestalteten flächigen Träger 1 aus einem elektrisch nicht leitfähigen Material, insbesondere aus einem starren oder flexiblen Kunststoffmaterial. Die äußere Kontur des Trägers 1 ist beispielhaft und kann in Abhängigkeit vom Einbauort bzw. in Abhängigkeit von dem Zielbauteil, auf oder in dem der Träger 1 angebracht werden soll, gewählt werden.

Der Träger 1 weist elektrisch leitfähige Strukturen 2 bis 4 auf, wobei auch nur eine einzige elektrisch leitfähige Struktur 2 oder mehr als drei elektrisch leitfähige Strukturen vorhanden sein können. Die Länge, Breite und Erstreckung der Strukturen 2 bis 4 ist ebenfalls rein beispielhaft. Im Wesentlichen kommt es darauf an, dass der Verlauf der elektrisch leitfähigen Struktur ihrer Funktion, insbesondere ihrer Funktion zum Senden und/oder Empfangen hochfrequenter Signale, entspricht. Neben dieser Funktion können die elektrisch leitfähigen Strukturen auch als stromführende Leitungen ausgebildet sein. Bei diesem Ausführungsbeispiel sind am Ende einer jeden elektrisch leitfähigen Struktur 2 bis 4 jeweils eine Kontaktstelle 5 bis 7 vorhanden, wobei diese Kontaktstellen 5 bis 7 nicht zwangsweise endseitig, sondern auch an anderer Stelle im Verlauf der elektrisch leitfähigen Struktur 2 bis 4 angeordnet sein können.

An dem einen Ende des Trägers 1 ist beispielhaft eine rechteckförmige Aussparung 12 vorhanden, während in deren Nähe eine weitere trapezförmige Aussparung 9 angeordnet ist. Auf der gegenüberliegenden Seite sind weitere kreisförmige Aussparungen 10 vorhanden. Diese beispielhaft dargestellten Aussparungen 8 bis 10 dienen vorzugsweise der Lagepositionierung des Trägers 1 in einem Stanzwerkzeug, in einem Spritzgusswerkzeug, in einem Schäumungswerkzeug, in Kompressionswerkzeugen oder in einem sonstigen Werkzeug.

Weiterhin weist der Träger 1 randseitige rundliche Einbuchtungen 11 oder randseitige eckige Einbuchtungen 12 auf. Auch diese Einbuchtungen 11, 12 sind hinsichtlich ihrer geometrischen Erstreckung und Anordnung an dem Rand des Trägers 1 beispielhaft und können entsprechend ihrer Funktion anders gestaltet werden. Diese Einbuchtungen 11, 12 können ebenfalls für die Ausrichtung des Trägers 1 in Bezug auf ein Werkzeug oder auch in Bezug auf das Zielbauteil verwendet werden.

Innerhalb der flächigen Erstreckung des Trägers 1 sind weiterhin beispielhaft eine rechteckige Aussparung 13 (voll umfänglich innerhalb des Trägers 1) und eine trapezförmige Aussparung 14 vorhanden, wobei sich die Aussparung 14 ebenfalls bis in den Randbereich des Trägers 1 erstreckt. Diese Aussparungen 13, 14 sind in solchen Bereichen vorhanden, in denen beispielsweise ein elektrisches oder elektronisches Gerät an dem Träger 1 und/oder an dem hier nicht dargestellten Zielbauteil befestigt wird, so dass diese Aussparungen als Positionier- und Montagehilfe dienen. Zwecks Kontaktierung können Kontaktierungsflächen in Randlage ausgerichtet werden, so dass das Signal über den seitlichen Zugriff abgegriffen werden kann. Vorteilhaft ist jedoch die Anwendung der bekannten On-Glass-Technologie, bei der ein Antennenverstärker in einem Halterahmen eingesetzt wird, der wiederum auf einer Fahrzeugscheibe aufgeklebt ist. Die Übertragung der mittels der auf der Fahrzeugscheibe angeordneten Antennenstrukturen empfangenen Signale erfolgt über Kontaktfedern zwischen dem Antennenverstärker und den Kontaktstellen der Antennenstrukturen. Gerade in diesem Falle ist die Ausstattung des Trägers mit den hierzu korrespondierenden Markierungen notwendig.

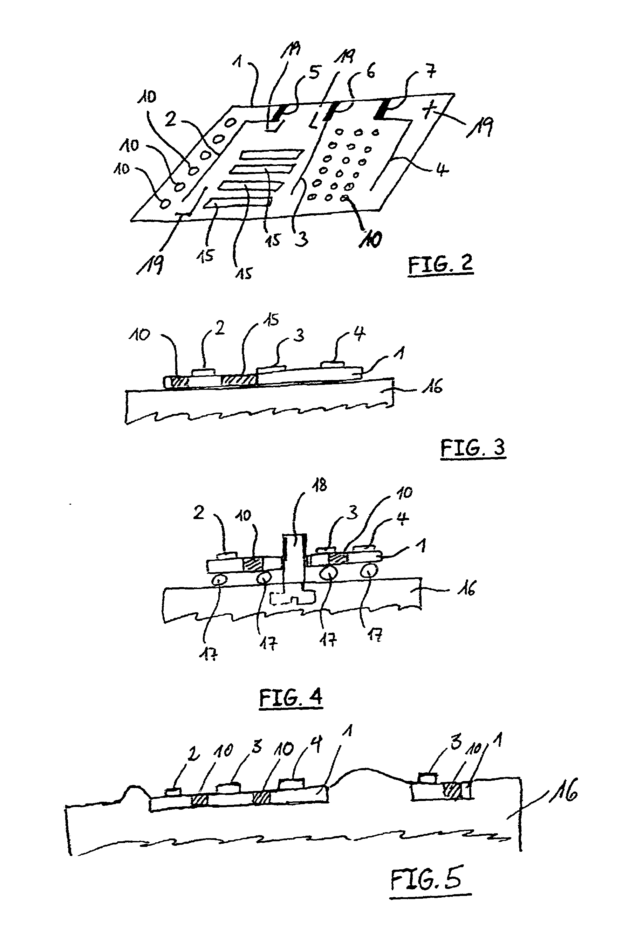

Figur 2 zeigt eine weitere Ausführungsform eines flächig gestalteten Trägers 1 für die Anwendung in Fahrzeugen, bei dem wiederum beispielhafte elektrisch leitfähige Strukturen 2 bis 4 mit Kontaktstellen 5 bis 7 aufgebracht sind. Bei dieser Ausführung sind mehrere Aussparungen 10 in einer Reihe in dem Träger 1 angeordnet. Angedeutet sind auch mehrere Reihen von Aussparungen 10 nebeneinander. Zweifellos ist es möglich, den gesamten Träger mit solchen Aussparungen auszustatten, um so das Ausgasen des hier nicht dargestellten Zielbauteils zu ermöglichen. Gleiches gilt für längliche, rechteckförmige Aussparungen 15. Aussparungen wie diese können jedoch auch zu generellen Positionierarbeiten genutzt werden. Die Markierungen 19 können ebenfalls der Ausrichtung des Trägers in einem Werkzeug oder der Positionierung von zusätzlichen Komponenten in Bezug auf den Träger dienen.

Figur 3 zeigt den Träger 1 gemäß Figur 2 (oder gemäß Figur 1), bei dem der Träger 1 zusammen mit einem Zielbauteil 16 flächig auf ein Zielbauteil gefügt wurde. Beispielhaft kann dies durch eine selbstklebende Folie realisiert werden, auf welche die leitenden Strukturen 2, 3 und 4 aufgebracht wurden. Durch die Aussparungen 10 und 15 kann nun das Zielbauteil 16 kontinuierlich ausgasen.

Figur 4 zeigt den flächigen Träger 1 gemäß Figur 2 (oder gemäß Figur 1), der auf das Zielbauteil 16 aufgeklebt wird, nachdem er mit den erforderlichen elektrisch leitfähigen Strukturen, Kontaktstellen und gegebenenfalls Einbuchtungen und/oder Aussparungen versehen worden ist. In dieser Ausführungsform weist der Träger 1 gemäß Figur 4 innerhalb seiner flächigen Erstreckung beispielhaft zu wenige Aussparungen für die Ausgasung auf. Um diese zu gewährleisten wird die Klebeverbindung mittels parallel verlaufender oder punktförmiger Kleberaupen, jedoch in jedem Falle partiellen Verklebung 17 realisiert ist. Hierdurch ist es nicht erforderlich, über die gesamte flächige Erstreckung Aussparungen für die Ausgasung vorzusehen. Sehr wohl aber können Aussparungen für die Positionierung weiterer Komponenten vorhanden sein. So ist zum Beispiel in Figur 4 noch gezeigt, dass der Träger 1 eine rundliche Aussparung 10 genau an der Stelle aufweist, an der aus dem Zielbauteil 16 eine Schraube 18 herausragt. Damit wird es möglich, dass der flächige Träger 1 planparallel zu dem Zielbauteil 16 angeordnet werden kann (gleiches gilt auch für die Ausführungsform gemäß Figur 3) und das Befestigungsmittel, hier beispielsweise die Schraube 18, schon mit Herstellung des Zielbauteiles 16 eingebracht werden kann. In einem solchen Fall ist es denkbar, das Befestigungsmittel oder mehrere Befestigungsmittel an dem Zielbauteil 16, insbesondere die Schraube 18, und die korrespondierende Aussparung (oder Einbuchtung) des Trägers 1 als Positionierhilfe für die korrekte Zuordnung vom Träger 1 zu dem Zielbauteil 16 heranzuziehen.

In den allen Figuren können auf der Oberfläche des Trägers 1 mannigfaltige Markierungen angebracht sein, die alternativ oder ergänzend vor allen Dingen in Bezug auf die Aussparung 13 als Positionierhilfe für ein zu montierendes elektronisches Gerät, Befestigungsmittel oder dergleichen dienen. Die gezeigten und beschriebenen und als Positionierhilfe bzw. Montagehilfe ausgebildeten Einbuchtungen und/oder Aussparungen sowie die auf der Oberfläche des Trägers 1 angebrachten Markierungen bieten damit den Vorteil, dass die Montage entweder manuell oder auch automatisiert verbessert wird.

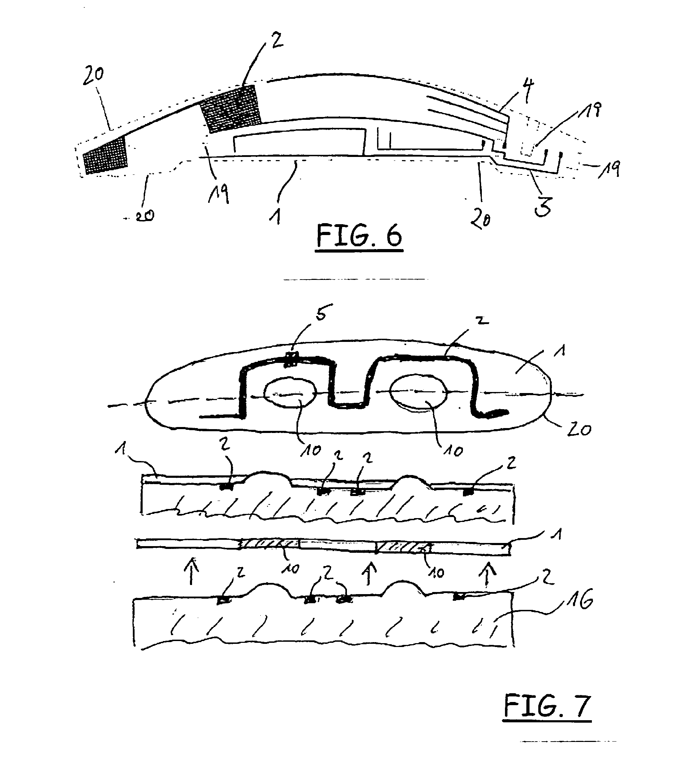

Figur 5 zeigt den integrierten Träger 1 nach der Fertigstellung des Zielbauteils 16. Verwendet wurde hierbei ein Hinterschäumungs-, Hinterspritz- oder Kompressionsverfahren. Beispielhaft sind Erhebungen im Zielbauteil 16 dargestellt, welche mit Aussparungen im Träger 1 freigestellt wurden. Dargestellt ist demzufolge ein Schnitt gemäß Figur 7. Der Träger 1 ist in diesem Beispiel in das Zielbauteil 1 eingebettet, könnte jedoch auch bei dementsprechender Werkzeugauslegung erhaben an das Zielbauteil 16 gefügt sein. Die Aussparungen 10 dienen auch hier wieder der Ausgasung des Zielbauteils 16.

Figur 6 ist eine weitere Ausführung eines flächigen Trägers 1. Beispielhaft sind Markierungen 19 dargestellt, mit deren Hilfe zusätzliche Komponenten in ihrer richtigen Lage positioniert werden können. Das Abgreifen von Signalen an den Kontaktierungsstellen ist hierdurch reproduzierbar, d.h. die miteinander zu kontaktierenden Kontaktstellen kommen in der korrekten Lage zueinander. Die leitenden Strukturen 2, 3 und 4 bilden hierbei ein Antennensystem. Außerdem verfügt der Träger 1 über eine definierte, abgestimmte und somit weiterverarbeitbare Kontur durch die Aussparungen und Einbuchtungen 20.

Figur 7 zeigt den Schnitt durch einen mit dem Transferverfahren hergestellten Träger 1 mit der leitenden Strukturen 5. Um den Träger 1 flächig in das Werkzeug einbringen zu können, wurden die Aussparungen und Einbuchtungen 10 und 20 vorgenommen, da das Zielbauteil über Erhebungen verfügt. Nach dem Positionierung des Trägers 1 im hier nicht dargestellten Werkzeug mit Hilfe der Aussparungen 10 wird das Werkzeug gefüllt und die eingebrachte Masse erstart. Die zur Masse gerichteten leitenden Strukturen gehen hierbei in oder auf die Oberfläche des entstehenden Zielbauteils über. Der Träger fungiert somit als Zwischenträger und kann gegebenenfalls wieder verwendet werden. Auch Markierungen können auf diese Art und Weise übertragen werden. Ohne Aussparungen bzw. Einbuchtungen wäre jedoch die für dieses Verfahren notwendige Positionierung des Trägers 1 nicht möglich.

Ein besonders wichtiges Einsatzgebiet und Anwendung des erfindungsgemäßen Trägers sind integrierte Antennensysteme, bei denen elektrisch leitfähige Strukturen auf flächigen Bauteilen eines Fahrzeuges anzubringen sind. Hier besteht insgesamt der Vorteil, dass der flächige Träger zunächst mit den elektrisch leitfähigen Strukturen versehen werden kann und aufgrund seiner Größe noch problemlos handhabbar ist, um ihn entweder auf einem vorgefertigten Zielbauteil des Fahrzeuges an- oder einzubringen oder ihn zusammen mit dem herzustellenden Zielbauteil zu fertigen. Dabei kann das Zielbauteil aus einem transparenten Material bestehen, wenn es sich beispielsweise um eine Fahrzeugscheibe (z.B. Heckscheibe) oder ein Panoramadach handelt. In einem solchen Fall besteht der flächige Träger ebenfalls aus einem transparenten Material, insbesondere einer durchscheinenden Kunststofffolie und die Breite der elektrisch leitfähigen Strukturen ist dabei so gewählt, dass sie von den Insassen des Fahrzeuges nicht oder nur kaum wahrgenommen werden. Für diesen Fall sei noch die Möglichkeit erwähnt, dass die elektrisch leitfähigen Strukturen parallel zueinander verlaufend angeordnet sind und von Strom durchflossen werden, um eine Beheizung der Scheibe zu realisieren.

### Bezugszeichenliste

- 1.: Träger
- 2.: elektrisch leitfähige Struktur
- 3.: elektrisch leitfähige Struktur
- 4.: elektrisch leitfähige Struktur
- 5.: Kontaktstelle
- 6.: Kontaktstelle
- 7.: Kontaktstelle
- 8.: Aussparung (rechteckig)
- 9.: Aussparung (trapezförmig)
- 10.: Aussparung (rund)
- 11.: Einbuchtung (rundlich)
- 12.: Einbuchtung (eckig)
- 13.: Aussparung (rechteckig)
- 14.: Aussparung (trapezförmig)
- 15.: Aussparung (rechteckig)
- 16.: Zielbauteil
- 17.: Kleberaupe
- 18.: Schraube
- 19.: Markierung
- 20.: Aussparung/Einbuchtung

## Patentansprüche

1. Flächiger Träger (1) aus einem elektrisch nicht leitfähigen Material, wobei auf oder in dem Träger (1) elektrisch leitfähige Strukturen (2, 3, 4) auf- oder eingebracht sind, ausgebildet zur Anwendung in einem Fahrzeug, **dadurch gekennzeichnet, dass** der Träger (1) randseitig zumindest eine Einbuchtung (11, 12) und/oder innerhalb seiner flächigen Erstreckung zumindest eine Aussparung (8, 9, 10, 13, 14) und/oder eine Markierung (19) aufweist.

2. Flächiger Träger (1) nach Anspruch 1, **dadurch gekennzeichnet, dass** die zumindest eine Einbuchtung (11, 12) und/oder die zumindest eine Aussparung (8, 9, 10, 13, 14) ausgestanzt ist.

3. Flächiger Träger (1) nach Anspruch 1 oder 2, **dadurch gekennzeichnet, dass** mehrere Aussparungen (8, 9, 10) in einer Reihe in dem Träger (1) angeordnet sind.

4. Flächiger Träger (1) nach einem der vorhergehenden Ansprüche, **dadurch gekennzeichnet, dass** mehrere Aussparungen (8, 9, 10) in mehreren Reihen nebeneinander angeordnet sind.

5. Flächiger Träger (1) nach einem der vorhergehenden Ansprüche, **dadurch gekennzeichnet, dass** der Träger (1) auf ein Zielbauteil (16) aufklebbar ist.

6. Flächiger Träger (1) nach einem der vorhergehenden Ansprüche, **dadurch gekennzeichnet, dass** der Träger aus PET oder PVC besteht und auf ein Zielbauteil (16) aus PUR-Schaum aufklebbar ist.

7. Flächiger Träger (1) nach einem der vorhergehenden Ansprüche, **dadurch gekennzeichnet, dass** der Träger transparent ist.

8. Flächiger Träger (1) nach Anspruch 5 oder 6, **dadurch gekennzeichnet, dass** die Klebeverbindung eine oder mehrere, vorzugsweise parallel verlaufende Kleberaupen (17) aufweist.

9. Flächiger Träger (1) nach einem der vorhergehenden Ansprüche, **dadurch gekennzeichnet, dass** der Träger (1) in ein Werkzeug einlegbar und mittels der zumindest einen Einbuchtung (11, 12) und/oder der zumindest einen Aussparung (8, 9, 10, 13, 14) und/oder zumindest einen Markierung in dem Werkzeug ausrichtbar und/oder lagefixierbar ist, wobei nach dem Einlegen das Werkzeug mit einem Werkstoff zur Herstellung eines Zielbauteils (16) aufgefüllt wird.

10. Flächiger Träger (1) nach einem der vorhergehenden Ansprüche, **dadurch gekennzeichnet, dass** der Träger (1) mittels der zumindest einen Einbuchtung (11, 12) und/oder der zumindest einen Aussparung (8, 9, 10, 13, 14) und/oder zumindest einen Markierung (19) die Positionierung von zusätzlichen aktiven und/oder passiven Komponenten ermöglicht.

11. Flächiger Träger (1) nach einem der vorhergehenden Ansprüche, **dadurch gekennzeichnet, dass** der Träger (1) mittels der zumindest einen Einbuchtung (11, 12) und/oder der zumindest einen Aussparung (8, 9, 10, 13, 14) und/oder zumindest einen Markierung (19) sowie den Strukturen (2, 3, 4) und den Kontaktstellen (5, 6, 7) ein Mehrantennensystem für ein Fahrzeug bildet.
